Europäisches Patentamt

European Patent Office

Office européen des brevets

(11) Publication number: **0 457 338 A1**

## EUROPEAN PATENT APPLICATION

(21) Application number: **91107990.3**

(22) Date of filing: **16.05.91**

(51) Int. Cl.5: **G07F 7/10**

(30) Priority: **16.05.90 JP 126139/90**
**29.05.90 JP 56218/90 U**
**15.04.91 JP 82266/91**

(43) Date of publication of application:
**21.11.91 Bulletin 91/47**

(84) Designated Contracting States:
**DE FR GB**

(71) Applicant: **SEIKO EPSON CORPORATION**
**4-1, Nishishinjuku 2-chome**
**Shinjuku-ku Tokyo-to(JP)**

(72) Inventor: **Hayashi, Yoshimitsu, c/o Seiko Epson Corp.**
**3-5, Owa 3-chome**
**Suwa-shi, Nagano-ken(JP)**
Inventor: **Nakamura, Norio, c/o Seiko Epson Corp.**
**3-5, Owa 3-chome**
**Suwa-shi, Nagano-ken(JP)**

(74) Representative: **Blumbach Weser Bergen Kramer Zwirner Hoffmann Patentanwälte**
**Radeckestrasse 43**
**W-8000 München 60(DE)**

(54) **IC card.**

(57) An IC card comprises a circuit board (1) on which a plurality of electronic elements (B1 - B4) are mounted and which is sealed inside of a frame (5) and external panels. The electronic elements are arranged to have an empty space with predetermined intervals between the individual elements. A pre-manufactured means (9) of a designated shape is mounted in said empty space between the circuit board (1) and an external panel to provide a reliable and inexpensive way of filling space between the circuit board and the external panel and to protect the electronic elements on the circuit board against forces applied to the IC card. The problem of an insufficient resin filling as it occurs with the prior art is thus avoided.

FIG. 3

EP 0 457 338 A1

The invention relates to an IC card having built-in a plurality of electronic elements.

Known IC cards use a gang bonding method to connect a semiconductor chip to leads provided on a film carrier tape, and have a built-in circuit module formed by mounting to a circuit board the external connection leads of a module having the active surface of the semiconductor chip protected by means of a mold material.

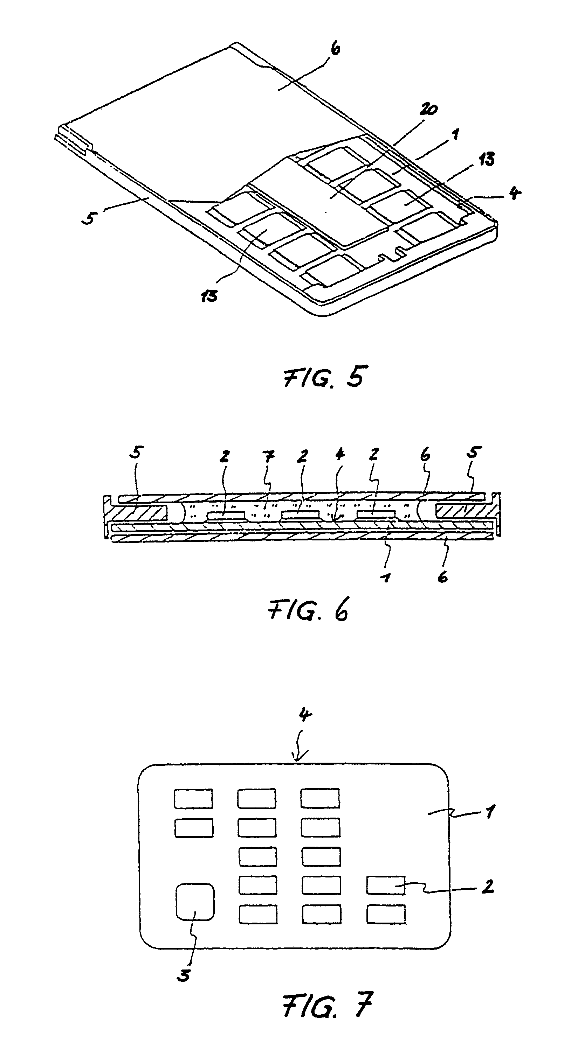

To facilitate the understanding of background of the present invention reference is first made to Fig. 6 showing a cross sectional view of a prior art IC card. Fig. 7 is a plan view showing the arrangement of circuit modules of this IC card. In the known IC card plural TAB modules 2 with memory semiconductor chips are mounted on a circuit board 1 in a regular array. Also mounted on the circuit board 1 is a TAB module 3 which has control semiconductor chips that control the memory semiconductor chips on TAB modules 2. The circuit board 1 with these modules on it forms a circuit module 4.

Circuit module 4 is attached to a frame 5 which is a rectangularly shaped basic frame unit of the IC card. The frame unit is sandwiched between two metallic external mounting plates 6. Numeral 7 designates resin used to fill up the space between the circuit module 4 and external metallic panels 6. One reason why the TAB modules 2 are arranged in a regular array on the circuit board 1 is that this allows for easy TAB mounting by machines making automation possible.

With the above described prior art IC cards, because of the resin 7 used to fill up the space between circuit module 4 and external panels 6, if such an IC card is pressed from the outside, there will be no sudden and acute local stress on a TAB module 2 preventing the semiconductor chip of the module 2 from breaking.

With this prior art, a great deal of effort is required, however, to fill up the spaces with resin 7, and this is a major hindrance to reducing the cost of the IC card. If spaces are insufficiently filled up by resin 7, the semiconductor chip of the TAB module 2 at the corresponding location may break if external pressure is applied, creating problem of inadequate IC card reliability.

The invention is intended to remedy these problems and to provide an IC card of a high reliability that can be produced at lower costs than the prior art IC cards.

This object is achieved by an IC card as claimed in the independent claims. Specific embodiments of the invention are claimed in the dependent claims.

With the invention, plural electronic elements are divided into plural blocks mounted on a circuit board such that empty space is created between the blocks at designated intervals. Within those empty spaces a furring of a designated shape is placed between the circuit board and the opposing external panel. The furring taking the place of the resin used in the prior art contributes to a major reduction in production costs as well as eliminating electronic element breakage and thus enhancing the reliability of the IC card.

If the furring is made integral with a frame, the number of assembly steps will decrease compared to that of the prior art. Moreover, by attaching the furring to the circuit board and to the external panel with an adhesive, there is an overall improvement of the stiffness or hardness of the IC card further decreasing the danger of a breakage of the electronic elements.

In another embodiment of the invention, by inserting a frame unit provided with holes for the plural electronic elements, between the circuit board and the opposing external panel the frame unit takes the place of the resin filler of the prior art. Such frame unit also allows a major reduction of the production costs and eliminates a breakage of the electronic elements. By attaching the frame unit to the circuit board and the external panel with an adhesive the effect of a further increase of stiffness or hardness of the overall IC card and a further reduced danger of a breakage of the electronic elements are achieved.

According to still another embodiment of the present invention one square-like empty space is formed between plural electronic elements on the circuit board. If a parallelepiped-like board spacer is placed in that space between the circuit board and the opposing external panel in place of the resin filler of the prior art, this allows for a major reduction of production cost and eliminates the danger of a breakage of electronic elements.

Since the board spacer is of a simple parallelepiped-like shape, it has the effect of preventing unnecessary expenditure on hardware and increasing the flexibility as regards mounting electronic elements on the circuit board, which results in an increase of the electronic element packing density. Also, by attaching the board spacer to the circuit board and to the external panel with an adhesive, the overall stiffness of the IC card is increased and a breakage of electronic elements further prevented.

The plural electronic elements mounted on the circuit board, themselves may be attached to the external panel by an adhesive. Thus, even if there is a small difference between the height of the electronic elements on the circuit board leading to different gap sizes between the electronic elements and the external panel, such differences can be compensated for by the adhesive. The frame, the panels and the spaces and each individual electronic element will become one single unit, and this will additionally contribute to an increase of the overall stiffness or hardness of the IC card.

Common to all of the above mentioned embodiments of the invention is that they provide a reliable and inexpensive way of filling space between the circuit board and the external panel in order to protect the electronic elements on the circuit board against forces applied to the IC card. The problem of an insufficient resin filling as it occurs with the prior art is thus avoided.

Embodiments of the present invention will be explained more in detail below with reference to the drawings, in which:

Fig. 1    is a cross sectional view of one embodiment of the present invention,

Fig. 2    is a top plan view of a circuit module of the embodiment shown in Fig. 1,

Fig. 3    is a top plan view of the same embodiment showing the frame and the furring on it,

Fig. 4    is a perspective view of a second embodiment of the invention,

Fig. 5    is a perspective view of a third embodiment of the invention,

Fig. 6    as a cross sectional view of a prior art IC card and

Fig. 7    is a top plan view of the circuit module of the IC card shown in Fig. 7.

Throughout the drawings, the same reference numerals are used to designate same or similar elements in order to avoid redundant descriptions.

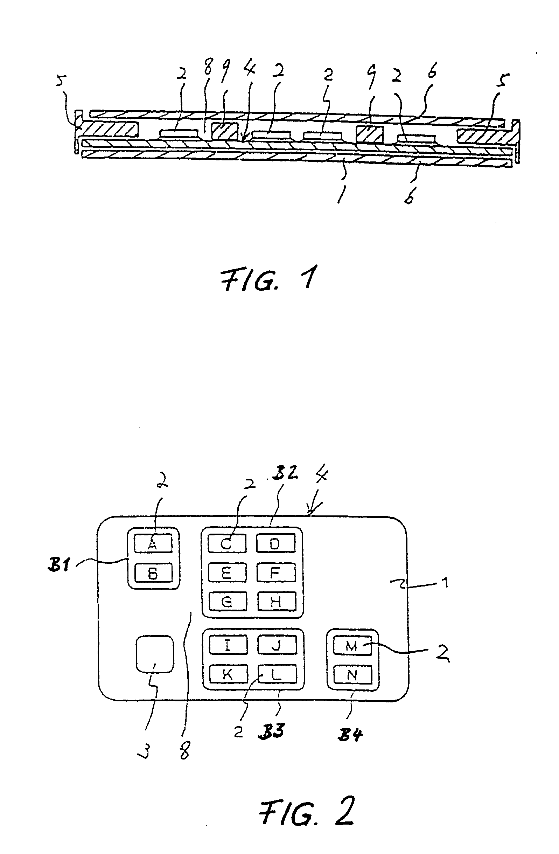

With reference to Figs. 1 to 3 a first embodiment of the present invention will be explained.

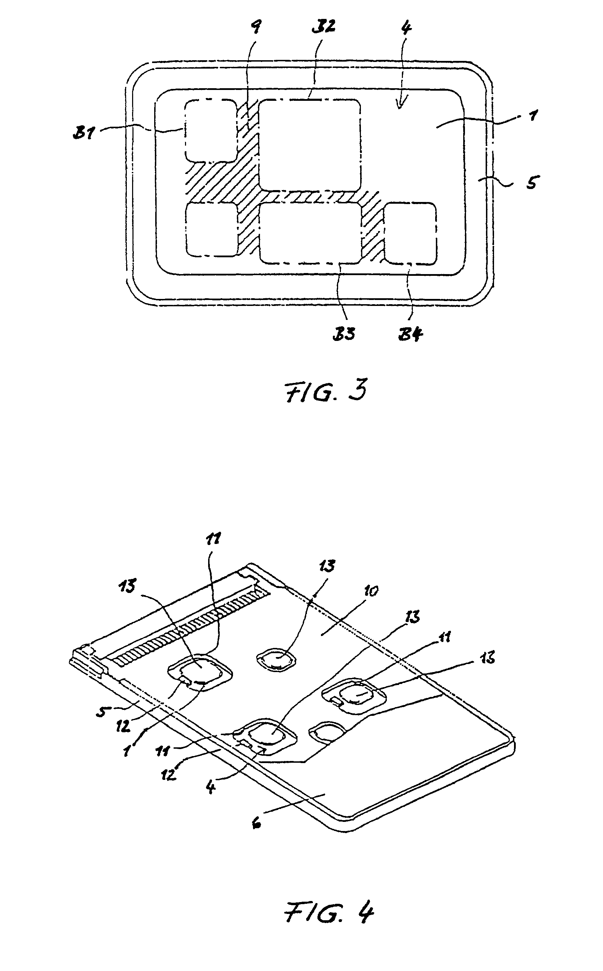

In Fig. 1, B1 represents a first block. This block is composed of a TAB module 2 which in turn is composed of two electronic elements A and B. Block B1 is mounted on circuit board 1. B2 represents a second block which is composed of a TAB module 2 which comprises six electronic elements C through H. The second block is also mounted on circuit board 1. A third block B3 is composed of a TAB module 2 comprising for electronic elements I through L. This block, too, is mounted on circuit board 1. A fourth block B4 is composed of a TAB module 2 comprising two elements M and N and is also mounted on circuit board 1. Blocks B1 through B4 are arranged on the surface of the circuit board 1 such that an empty space 8 of a designated shape and a minimum width of 2 mm between adjacent blocks is formed. Numeral 9 (the hatched portion in Fig. 3) designates a furring of a designated shape corresponding to the shape of the empty space 8. The furring is placed between circuit board 1 and the opposing external panel 6 (the upper one of the two panels 6 in Fig. 1). In the present case furring 9 has been formed integrally with frame 5, but may, however, be formed as a unit separate from frame 5.

In the IC card explained above, the furring takes the place of the resin filler (7 in Fig. 6) of the prior art IC card. The furring, in addition to contributing to a reduction in production costs, avoids the problem of locally insufficient resin filling, so that the problem of a break of a semiconductor chip in a TAB module 2 does no longer exist. These factors lead to an enhanced reliability. Moreover, by fabricating furring 9 as an integral part of frame 5, the number of assembly steps can be decreased as compared to the prior art. The mechanical strength of the IC card according to the invention was tested. Especially, when the entire IC card was bent and twisted and exposed to concentrated pressure on the TAB module 2 portion of the card, the results were the same as those with a prior art IC card sufficiently filled with resin.

By attaching furring 9 to circuit board 1 and external panel 6 with an adhesive, the overall stiffness or hardness the IC card is improved, further preventing a breakage of a TAB module 2. In this embodiment, plural TAB modules 2 are separate into blocks as shown in Fig. 2. However, it goes without saying that the TAB modules 2 can be changed as desired in terms of the number and size of the modules. However, as much as possible, it is most desirable to have a uniform block breakup and have furring 9 be of a simple shape in order to keep production costs down.

Fig. 4 is perspective view of a second embodiment of the present invention. This embodiment has a frame unit 10 provided between circuit board 1 and the external panel 6, which covers the surface of the circuit board 1. Plural holes 11 are formed in frame unit 10 to accommodate chips 12 and integrated circuits 13 mounted on the circuit board 1.

In this embodiment, in order to increase the stiffness or hardness of the overall IC card, holes 11 have been formed at locations only were it is necessary to allow play for chip elements 12 or integrated circuits 13, in order to strengthen the attachment of frame unit 10 to external panel 6 as much as possible. In this embodiment, the frame unit 10 takes the place the filler resin of the prior art. The frame unit 10 allows a major reduction in production costs and prevents the breakage of chips 12 or integrated circuits 13 and additionally reduces the number of assembly steps as compared to that of the prior art.

In addition, by attaching frame unit 10 to circuit board 1 and external panel 6 with an adhesive, the overall stiffness or hardness of the IC card is increased and the danger of a breakage of a chip 12 or an integrated circuit 13 further reduced.

Fig. 5 is a perspective view of a third embodiment of the present invention. In this embodiment, an elongated board spacer 20 of a rectangular cross-section is arranged in the empty space formed between plural integrated circuit 13 which are the electronic elements mounted on circuit board 1. The board spacer has a thickness of about the same dimension as the gap between the circuit board and the external panel 6. The board spacer 20 is first attached to the circuit board 1 by means of an adhesive and then attached to external panel 6 when this is attached to the frame 5.

In this embodiment the board spacer 20 takes the place of the resin filler of the prior art. As with the previous embodiments the board spacer 20 allows a substantial reduction of production costs and prevents the breakage of integrated circuits 13 and additionally reduces the number of assembly steps.

Different from the first and second embodiments, where it is necessary to design furring 9 or frame unit 10, respectively, to have a specific shape for each individual IC card, the board spacer 20 of the third embodiment may have a parallelepiped-like shape allowing a high degree of standardization, i.e. the types of board spacers 20 can be kept to a minimum. As a result, unnecessary hardware costs can be avoided. Moreover, by using a board spacer 20 of same shape in a variety of IC card modules the unit price is further reduced.

In addition to this, the space between the plural integrated circuits 13 is of a simple square-like shape. Therefore, there is an increase in the flexibility of mounting integrated circuits 13 on circuit board 1 allowing an increase of the electronic element packing density.

As with the previous embodiments, the integrated circuits 13 mounted on the circuit board 1 can be attached to the external panel 6 by means of an adhesive. If the height of the integrated circuits 13 on circuit board 1 and/or the interval between external panel 6 and circuit board 1 are slightly different, that difference will be compensated for. Frame 5, external panels 6, board spacer 20 and integrated circuits 13 will be combined to a single unit to further increase the overall stiffness or hardness the IC card, thus, reducing the danger of breakage of the integrated circuits 13.

## Claims

1. An IC card comprising a circuit board (1) on which a plurality of electronic elements (2) are mounted and which is sealed inside of a frame (5) and external panels (6), **characterized** in that plural blocks (B1, B2, B3, B4) each comprising plural electronic elements are formed and arranged on the circuit board (1) such that an empty space on the circuit board with predetermined intervals between the individual blocks is established, and that a furring (9) of a designated shape is mounted in said empty space between the circuit board (1) and the external panels (6).

2. The IC card according to claim 1, **characterized** in that the furring (9) forms an integral part of the frame (5).

3. The IC card according to claim 1 or 2, **characterized** in that the furring (9) is attached to the circuit board (1) and the external panels (6) with an adhesive.

4. An IC card comprising a circuit board (1) on which plural electronic elements are mounted and which is sealed inside of a frame (5) and external panels (6), **characterized** in that a frame unit (10) with holes (11) for the plural electronic elements (12, 13) in it is inserted between the circuit board (1) and the external panels (6).

5. The IC card according to claim 5, **characterized** in that the frame unit (10) is attached to the circuit board (1) and the external panels (6) with an adhesive.

6. An IC card comprising a circuit board (1) on which plural electronic elements (13) are mounted and which is sealed inside a frame (5) and external panels (6), **characterized** in that at least one square-like empty space is formed on the circuit board, and that a square-shaped board spacer (20) is placed within said empty space between the circuit board (1) and the external panels (6).

7. The IC card according to claim 6, **characterized** in that the square-shaped board spacer is attached to the circuit board (1) and the external panels (6) with an adhesive.

8. The IC card according to claim 6 or 7, **characterized** in that the plural electronic elements (13) mounted on the circuit board (1) are attached to the external panels (6) with an adhesive.

FIG. 1

FIG. 2

FIG. 3

FIG. 4

FIG. 5

FIG. 6

FIG. 7

7

| DOCUMENTS CONSIDERED TO BE RELEVANT | | | EP 91107990.3 |
|---|---|---|---|
| Category | Citation of document with indication, where appropriate, of relevant passages | Relevant to claim | CLASSIFICATION OF THE APPLICATION (Int. Cl.5) |
| A | EP - A2 - 0 167 044 (CASIO COMPUTER COMPANY LIMITED) * Totality * | 1-8 | G 07 F 7/10 |
| A | DE - A1 - 3 131 216 (GAO GESELLSCHAFT FÜR AUTOMATION UND ORGANISATION MBH) * Totality * | 1 | |
| A | US - A - 3 702 464 (CASTRUCCI) * Totality * | 1 | |
| A | GB - A - 2 075 732 (J.W. HALPERN et al.) * Totality * | 1 | |
| | | | TECHNICAL FIELDS SEARCHED (Int. Cl.5) |
| | | | G 07 F 7/00 G 06 K 19/00 |

The present search report has been drawn up for all claims

| Place of search | Date of completion of the search | Examiner |
|---|---|---|
| VIENNA | 13-08-1991 | BEHMER |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)